(19) Europäisches Patentamt
European Patent Office
Office européen des brevets

(11) **EP 2 990 375 B1**

(12) **FASCICULE DE BREVET EUROPEEN**

(45) Date de publication et mention
de la délivrance du brevet:
**16.08.2017 Bulletin 2017/33**

(51) Int Cl.:
***B81B 3/00*** *(2006.01)*     ***G02B 26/08*** *(2006.01)*
***H02K 19/10*** *(2006.01)*

(21) Numéro de dépôt: **15182767.2**

(22) Date de dépôt: **27.08.2015**

(54) **DISPOSITIF MICROMÉCANIQUE À ACTIONNEMENT ÉLECTROMAGNÉTIQUE**

MIKROMECHANISCHE VORRICHTUNG MIT ELEKTROMAGNETISCHER BETÄTIGUNG

ELECTROMAGNETICALLY ACTUATED MEMS

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **01.09.2014 CH 13152014**

(43) Date de publication de la demande:
**02.03.2016 Bulletin 2016/09**

(73) Titulaire: **MEMS Technology Ltd.
9494 Schaan (LI)**

(72) Inventeurs:
• **Kuenlin, Vincent**
**1700 Fribourg (CH)**
• **Marxer, Cornel**
**2000 Neuchâtel (CH)**

(74) Mandataire: **Riederer Hasler & Partner
Patentanwälte AG
Elestastrasse 8
7310 Bad Ragaz (CH)**

(56) Documents cités:
**WO-A1-2013/065126     WO-A1-2013/168485**

**Description**

La présente invention est relative aux microsystèmes électromécaniques, plus connus sous l'appellation MEMS de l'anglais microelectromechanical systems. Elle concerne plus précisément un dispositif micromécanique comportant un élément actif mobile selon au moins un axe de rotation, et des moyens d'actionnement de type électromagnétique.

De tels dispositifs micromécaniques sont généralement des dispositifs optiques, dont l'élément actif est constitué d'un miroir mobile selon au moins un axe de rotation, relié à un support à l'aide de deux poutres élastiques en torsion définissant ledit axe de rotation. Ils sont classiquement fabriqués à partir de plaques de silicium, par des procédés de photolithographie bien connus de l'homme de métier.

Le fonctionnement de ces dispositifs est de type statique ou dynamique. Dans le mode statique, ils forment généralement des commutateurs optiques destinés à commuter un faisceau lumineux entre des positions angulaires fixes. En mode dynamique, le miroir balaye un faisceau lumineux sur un espace angulaire déterminé, et les dispositifs micromécaniques correspondant équipent, notamment, des spectromètres optiques, des imprimantes, des appareils d'imagerie médicale ou des capteurs de lumière.

On s'intéresse ici à des dispositifs micromécaniques, de type statique ou dynamique, actionnés de manière électromagnétique à l'aide d'un rotor, formé d'au moins une spire conductrice montée solidaire de l'élément mobile, et d'un stator, comportant deux pôles séparés par un entrefer dans lequel prend place le rotor. De tels dispositifs sont décrits, par exemple, dans les documents WO2009/147304 et US2008/0143196. Leur principe de fonctionnement est basé sur l'exploitation de la force de Laplace, soit la force $\vec{F}_L$ exercée par un champ magnétique $\vec{B}$ sur un conducteur de longueur $l$ parcouru par un courant $\vec{I}$, perpendiculairement au plan formé par le champ $\vec{B}$ et le courant $\vec{I}$ :

$$\vec{F}_L = \vec{I} \cdot l \times \vec{B}$$

L'élément mobile, muni de la spire conductrice, baigne dans le champ magnétique B généré par les pôles et traversant l'entrefer du stator. Lorsqu'un courant I parcourt la spire conductrice, une force s'exerce F sur la spire, perpendiculairement au plan du miroir, entraînant ce dernier en rotation. L'intensité de la force F est proportionnelle aux intensités du champ B et du courant I, et au sinus de l'angle entre B et I. Elle est donc maximale sur les portions de spire perpendiculaires au champ magnétique B, et nulle sur celles parallèles au champ B.

De tels dispositifs ne sont pas exempts d'inconvénients. En premier lieu, l'intensité de la force de Laplace est proportionnelle à l'intensité du champ B. Or, l'induction magnétique est d'autant plus faible à l'intérieur de l'entrefer, que ce dernier est large. C'est le cas, par exemple, du dispositif micromécanique décrit par le document WO2009/147304. Les pôles, formés de couches aimantées, définissent un entrefer dans lequel prend place l'ensemble miroir mobile - rotor. Le champ magnétique B régnant à l'intérieur de l'entrefer agit globalement sur l'ensemble de la spire conductrice, entre deux pôles éloignés en regard de leur polarisation magnétique. Il en ressort que l'intensité du champ B dans l'entrefer est faible et d'orientation mal définie, et ne permet pas l'application de forces de torsion importantes.

D'autre part, il est utile de pouvoir actionner le miroir selon deux axes de rotation. Une construction permettant cette fonction est décrite dans la demande US2008/0143196. Le miroir mobile est relié à un premier cadre à l'aide de deux poutres de torsion définissant un premier axe de rotation, lequel est lui même relié à un support par l'intermédiaires de deux autres poutres de torsion perpendiculaires aux premières et définissant un deuxième axe de rotation. Une première et une deuxième spires conductrices, formant respectivement un premier et un deuxième rotors, s'étendent respectivement à la périphérie du miroir et du cadre, tous deux de forme carrée. Deux de leurs côtés sont parallèles au premier axe de rotation, tandis que les deux autres côtés sont parallèles au deuxième axe de rotation. Le problème d'une telle structure réside dans le fait qu'il n'est pas possible d'établir deux champs magnétiques agissant indépendamment l'un de l'autre selon deux directions perpendiculaires, car les champs magnétiques se superposent. Par conséquent, aux fins d'actionner le miroir selon les deux axes de rotation, un champ magnétique unique B est appliqué à l'ensemble de la structure selon une direction formant un angle de 45 degrés entre les deux axes de rotation. Il en résulte que les forces appliquées au cadre et au miroir sont minorées par un facteur 0.7 correspondant au sinus de l'angle entre le champ B et le courant I.

Enfin, l'application d'un champ magnétique sur l'ensemble d'une structure micromécanique comportant un ou plusieurs miroirs, implique d'être attentif au sens de circulation du courant dans les différentes portions de rotor. En particulier, le sens du courant dans les deux portions de rotor parallèles à l'axe de rotation du miroir doit être opposé, sous peine d'appliquer des forces F s'équilibrant et un moment de rotation nul. De ce fait, la géométrie des rotors est, la plupart du temps, limitée à celle d'une spire rectangulaire, du type de celle divulguée dans le document WO2009/147304. Dans cette configuration, les brins entrant et sortant du rotor passent nécessairement par la même poutre de torsion et leur largeur est limitée à environ un quart de celle de la poutre afin d'éviter tout court-circuit. Cette contrainte géométrique a pour effet de restreindre l'intensité maximale du courant I circulant dans le rotor, et, par voie de conséquence, la force F appliquée au miroir. Un autre dispositif micromécanique est également connu de WO 2013/168485.

Le but de la présente invention est de remédier aux inconvénients précités, en proposant un dispositif micromécanique à actionnement électromagnétique, apte à appliquer des forces de torsion importantes selon deux axes de rotation, grâce à un champ magnétique puissant et d'orientation bien définie. Plus précisément, l'invention concerne un dispositif micromécanique à actionnement électromagnétique comportant un support, un élément actif monté mobile en rotation sur le support suivant un premier axe AA, un premier rotor, formé d'au moins une ligne électrique conductrice, monté solidaire en rotation de l'élément actif, et un premier stator comprenant au moins deux pôles magnétiques opposés séparés par un entrefer dans lequel prend place partiellement le rotor. Selon l'invention, le rotor comprend un premier segment séparé de l'élément actif par un premier espace vide, et le stator est positionné à l'intérieur du support de manière à recevoir le segment dans son entrefer, ses pôles étant disposés de part et d'autre du segment, l'un d'eux prenant place à l'intérieur du premier espace vide. Toutes les lignes conductrices du segment traversent l'entrefer et transportent le courant dans le même sens et de manière perpendiculaire au champ magnétique B formé par les deux pôles. Grâce aux caractéristiques du dispositif micromécanique selon l'invention, et en particulier grâce à la présence d'un espace vide entre un segment de la ligne conductrice et l'élément actif, permettant aux pôles du stator de prendre place directement de part et d'autre dudit segment, le champ magnétique B exercé par le stator n'est présent, ni n'agit, globalement sur l'ensemble du rotor, mais localement au niveau d'une portion de celui-ci.

Le confinement du champ magnétique B au niveau d'un segment du rotor permet, en premier lieu, d'augmenter son intensité locale et, conséquemment, la force F d'actionnement de l'élément actif, sans accroissement du courant I circulant dans la spire conductrice. L'efficacité du dispositif selon l'invention s'en trouve grandement améliorée. D'autre part, l'action locale d'un premier stator au niveau d'un rotor solidaire de l'élément actif, rend possible l'action locale d'un deuxième rotor, dans une direction perpendiculaire au premier. En effet, le confinement du champ magnétique $B_1$ localement au niveau d'un segment de rotor, permet à un deuxième champ magnétique $B_2$ voisin, d'agir également localement sans se superposer au premier. Il devient dès lors possible d'actionner l'élément actif selon deux axes de rotation, à l'aide de champs magnétiques $B_1$ et $B_2$ agissant selon deux directions perpendiculaires. La perte en puissance d'un facteur 0.7 relevée dans l'état de la technique n'est plus observée, et le dispositif gagne encore d'autant en efficacité.

D'autres caractéristiques et avantages de la présente invention apparaîtront à la lecture de la description qui suit, donnée uniquement à titre d'exemple et faite en référence aux dessins annexés dans lesquels :

- les figures 1 et 2 sont des vues schématiques respectivement de dessus et en perspective d'un dispositif micromécanique selon l'invention, mobile selon un axe de rotation,
- la figure 3 représente une variante avantageuse du dispositif illustré en figures 1 et 2,
- la figure 4 est une vue en perspective d'un dispositif micromécanique selon l'invention, mobile selon deux axes de rotation,
- la figure 5 est une vue schématique de dessus d'une variante simplifiée d'un dispositif micromécanique selon l'invention, mobile selon un axe de rotation,
- les figures 6 et 7 sont des vue en coupe schématiques de stators équipant le dispositif micromécanique selon l'invention,
- les figures 8 et 9 illustrent des vues respectivement de dessus et de dessous d'un mode de réalisation particulièrement avantageux d'un dispositif micromécanique selon l'invention, et
- la figure 10 est une vue en perspective d'une coupe d'un stator équipant ledit dispositif.

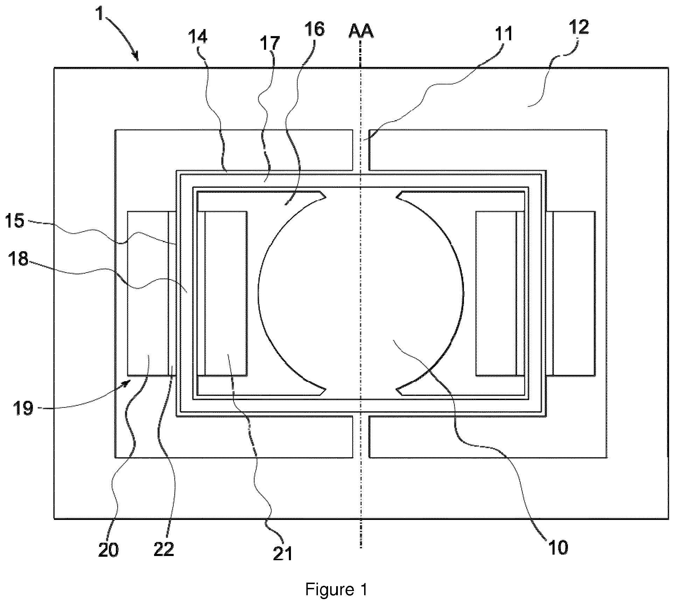

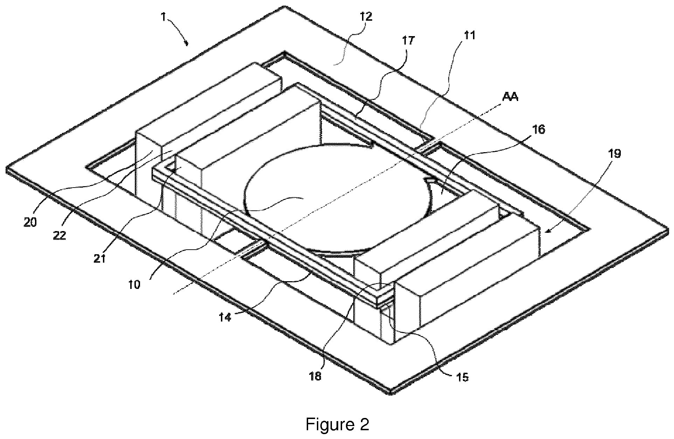

Le dispositif micromécanique à actionnement électromagnétique représenté en figures 1 et 2, et référencé dans son ensemble 1, comporte classiquement un élément actif 10, formé d'un miroir, monté mobile en rotation selon un axe AA, par l'intermédiaire de deux poutres de torsion 11, sur un support 12. En variante, l'élément actif 10 est constitué d'un réseau, d'une lentille, ou de tout autre composant actif optiquement. L'ensemble est essentiellement plan, et fabriqué, par exemple, en silicium, à l'aide de techniques de micro-fabrication bien connues de l'homme de métier.

Selon l'invention, un cadre 14 est monté solidaire en rotation de l'élément actif 10, au niveau de la jonction entre les poutres de torsion 11 et l'élément actif 10. En variante, le cadre 14 peut être monté directement sur les poutres de torsion 11, ou, sur l'élément actif 10 lui-même. De géométrie rectangulaire, ou carrée, ou tout autre géométrie de symétrie axiale AA, le cadre 14 comporte deux côtés 15 parallèles et symétriques par rapport à l'axe AA, chacun d'eux étant séparé de l'élément actif 10 par un espace vide 16 dont la fonction apparaîtra par la suite. En pratique, l'ensemble composé du miroir 10, du support 12 et du cadre 14, est fabriqué d'une seule pièce à partir d'une plaquette de silicium, lors d'une même opération de lithographie.

Un rotor 17, formé d'une ligne conductrice destinée à conduire un courant I, est monté solidaire du cadre 14 et conforme à sa géométrie. Dans la configuration illustrée en figures 1 et 2, ledit rotor forme classiquement une spire rectangulaire entrant et sortant par une des poutres de torsion 11. Il est constitué, par exemple, d'une piste métallique déposée sur le cadre 14, d'une bobine métallique collée audit cadre 14, ou de tout autre enroulement susceptible de conduire un courant I. Le rotor 17 est monté en face avant du cadre 14, mais peut être indifféremment fixé à sa face arrière, en fonction des contraintes structurelles ou fonctionnelles du dispositif 1. Les deux segments de rotor 18 portés par les côtés 15 du cadre 14, forment deux portions de conducteur parallèles à l'axe AA de rotation de l'élément actif 10, symétriques par rapport à lui, et dégagés de matière de toutes parts.

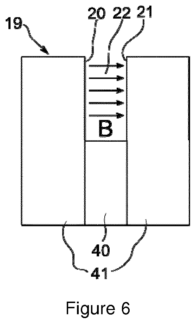

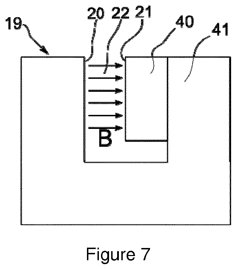

Le dispositif micromécanique 1 décrit en regard des figures 1 et 2, comporte encore une paire de stators 19 munis, chacun, de deux pôles magnétiques opposés, respectivement 20, 21, séparés par un entrefer 22 traversé par un champ magnétique B. Lesdits stators 19 sont dimensionnés et agencés pour prendre place à l'intérieur du support 12, symétriquement par rapport à l'axe AA, et recevoir lesdits segments de rotor 18 dans leur entrefer respectif 22. A cet effet, les pôles opposés 20, 21 sont eux-mêmes adaptés en taille et en forme pour prendre place, respectivement, de part et d'autre des segments 18, l'un d'entre eux étant disposé dans l'espace 16. Les entrefers 22 forment, quant à eux, un logement suffisamment grand pour recevoir les segments 18, tout en étant assez étroits pour confiner au maximum le champ magnétique B et le maintenir constant dans leur volume. A titre indicatif, on a représenté en figures 6 et 7 deux exemples de stator 19, dont la structure est particulièrement adaptée au dispositif micromécanique 1 selon l'invention. Lesdits stators 19 comprennent au moins un aimant permanent 40, accolé à une structure en matériau ferromagnétique 41, laquelle comporte un ou plusieurs éléments agencés de manière à former, avec l'aimant 40, un U.

Le principe de fonctionnement du dispositif micromécanique 1 selon l'invention est identique à celui d'un dispositif selon l'état de la technique. Lorsqu'un courant I circule dans le rotor 17, une force F agit sur les segments 18, perpendiculairement au plan du dispositif, actionnant l'élément actif 10 en rotation autour de l'axe AA. Toutefois, ses caractéristiques structurelles lui confèrent des avantages importants en terme de performance et d'efficacité.

Grâce au cadre 14 solidaire de l'élément actif 10, mais séparé de lui par deux de ses côtés 15, et aux deux stators 19 coopérant individuellement avec des portions de rotor 18, le champ magnétique B agit localement sur les segments de rotors 18 qui lui sont perpendiculaires, et non globalement sur l'ensemble de celui-ci. Le faible écartement entre les pôles 20, 21, permet d'obtenir un champ magnétique dans les entrefers 22 élevé, rendant possible l'actionnement en rotation de l'élément actif 10 avec un courant I faible. De plus, les lignes de champ magnétique B dans l'entrefer 22 sont d'orientation bien définie, perpendiculaire aux segments 18, d'où l'absence de pertes dues à un défaut de perpendicularité entre B et I. Il en ressort que le dispositif micromécanique 1 est d'efficacité sensiblement plus élevée que les dispositifs du même type appartenant à l'état de la technique. On note encore, que le confinement du champ magnétique B dans les entrefers 22, rend le dispositif micromécanique 1 peu sensible à d'éventuelles perturbations magnétiques extérieures, contrairement aux dispositifs existants.

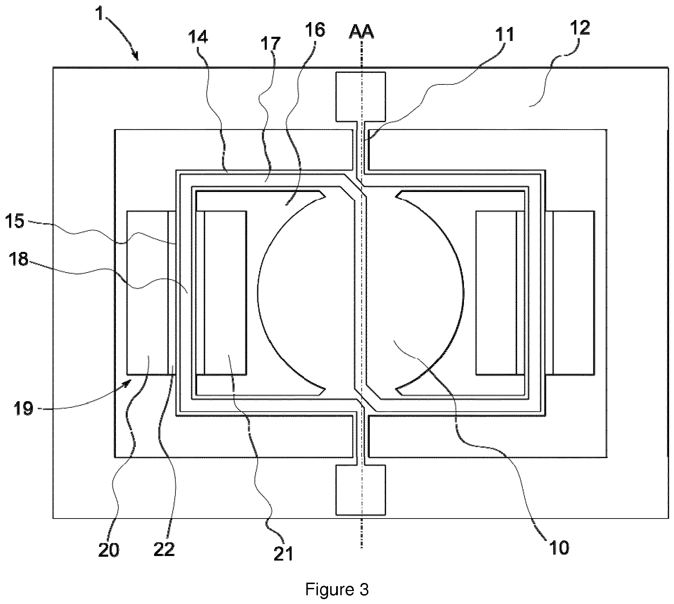

Un autre bénéfice, lié à la structure innovante du dispositif micromécanique selon l'invention, apparaît clairement en regard de la figure 3 représentant un dispositif micromécanique selon l'invention dans lequel la géométrie du rotor 17 est optimisée afin de conduire un courant d'intensité maximale. Dans cette configuration, le rotor est formé d'une ligne conductrice dessinant un 8 dont les brins entrant et sortant passent respectivement par l'une et l'autre poutre de torsion 11. Cet agencement est rendu possible par le positionnement local des stators 19, grâce auquel le sens de circulation du courant dans un segment 18 est indépendant du sens de circulation du courant dans l'autre segment 18 du point de vue de l'application de la force F. Il permet de doubler la largeur de la ligne conductrice formant le rotor 17 par rapport à l'état de la technique, et d'augmenter d'autant l'intensité du courant I et de la force F qui en résulte.

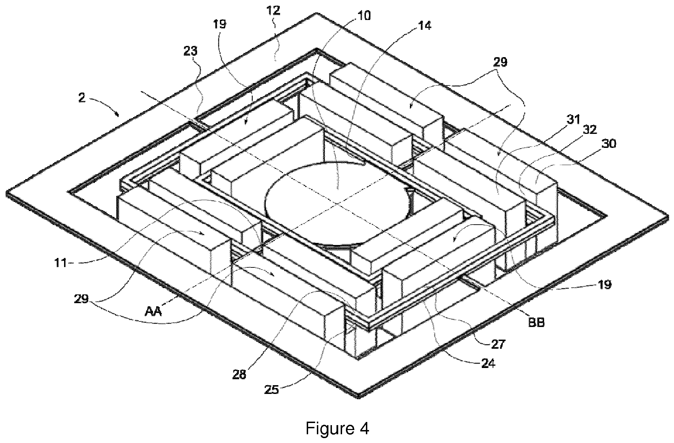

On considère maintenant un dispositif selon l'invention mobile selon deux axes de rotation, tel que représenté en figure 4. Ledit dispositif, référencé dans son ensemble 2, se distingue du dispositif décrit en regard des figures 1 à 3, en ce qu'il comporte un deuxième cadre 24, interposé entre le cadre 14 et le support 12. Le cadre 24 est monté mobile en rotation sur le support 12 selon un axe BB, perpendiculaire à l'axe AA, par l'intermédiaire de deux poutres de torsion 23. L'élément actif 10 et le cadre 14 sont, quant à eux, montés mobile en rotation selon l'axe AA indirectement sur le support 12, par l'intermédiaire de poutres de torsion 11 reliées au cadre 24 lui même monté sur le support 12.

De façon similaire au cadre 14, le cadre 24 comporte deux côtés 25 parallèles et symétriques par rapport à l'axe BB, les côtés 25 étant, par construction, dégagés de matière de part et d'autre. Le cadre 24 porte un deuxième rotor 27, formé d'au moins une ligne conductrice, monté conforme à sa géométrie. Les segments de rotor 28 solidaires des côtés 25 forment, semblablement aux segments 18, des portions de conducteur parallèles à l'axe BB, actives pour l'actionnement du dispositif 1.

Le dispositif micromécanique 2 comporte encore deux paires additionnelles de stators 29 dimensionnés et agencés pour prendre place à l'intérieur du support 12, symétriquement par rapport aux axes AA et BB, et recevoir lesdits segments de rotor 28 dans leur entrefer respectif 32. A cet effet, les pôles 30, 31 des stators 29, prennent place de part et d'autre des segments 28, et leur entrefer 32 est dimensionné pour loger les segments de rotor 28, tout en confinant au maximum le champ magnétique B.

Le principe de fonctionnement de ce dispositif micromécanique 2 est identique au précédent. Le confinement du champ magnétique B autour des segments de rotor 18, 28, procure les mêmes avantages que ceux déjà mentionnés, à savoir l'efficacité énergétique et la résistance du dispositif aux perturbations magnétiques extérieures. Il permet, au surplus, un gain en performance substantiel, à savoir l'actionnement de l'élément actif selon un deuxième axe de rotation BB. En effet, l'action locale du champ magnétique B permet de disposer des stators à proximité les uns des autres, sans perturbation ni interaction entre eux. Cette caractéristique confère une grande flexibilité dans le la structure du dispositif micromécanique selon l'invention. En particulier, les stators peuvent être distribués perpendiculairement les uns aux autres, de manière à actionner le miroir 10 selon deux axes de rotation, et cela sans perte d'un facteur 0.7, comme tel est le cas pour un dispositif comportant un unique stator agissant sur un ou plusieurs rotors. Ce bénéfice se cumule aux précédents, car les avantages précités restent valables selon les deux axes de rotation.

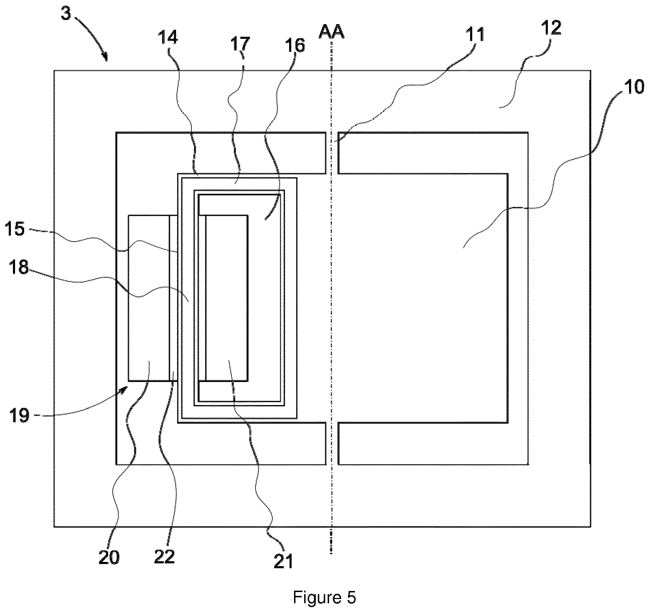

On se réfère maintenant à la figure 5 qui illustre un mode de réalisation simplifié d'un dispositif micromécanique selon l'invention, mobile suivant un axe de rotation. Le dispositif micromécanique représenté en figure 5, et référencé dans son ensemble 3, se distingue du dispositif 1, en ce que le cadre 14, solidaire de l'élément actif 10, s'étend d'un côté seulement de l'axe AA. Le rotor 17 ne comporte qu'un unique segment 18 parallèle à l'axe AA et séparé de l'élément actif 10 par un espace 16. Un unique stator 19 prend place à l'intérieur du support 12 pour actionner l'élément actif 10 en rotation, le segment 18 étant disposé dans l'entrefer 22 du stator 19. Le mode de fonctionnement de ce dispositif est similaire à celui du dispositif décrit en regard des figures 1 et 2, mais il est de structure simplifiée. En raison de sa petite taille, et en particulier du poids très faible de l'élément actif 10 en comparaison de la force électromagnétique d'actionnement F, la dissymétrie du système ne pose aucun problème fonctionnel.

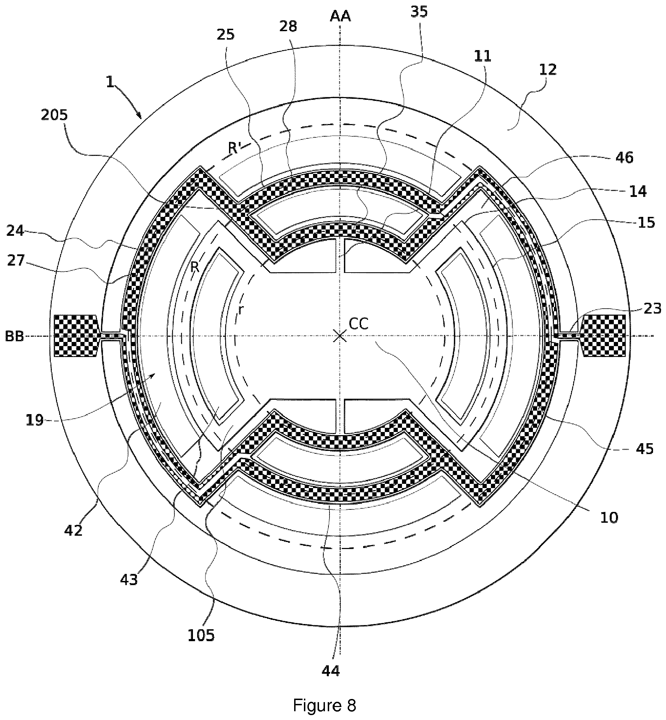

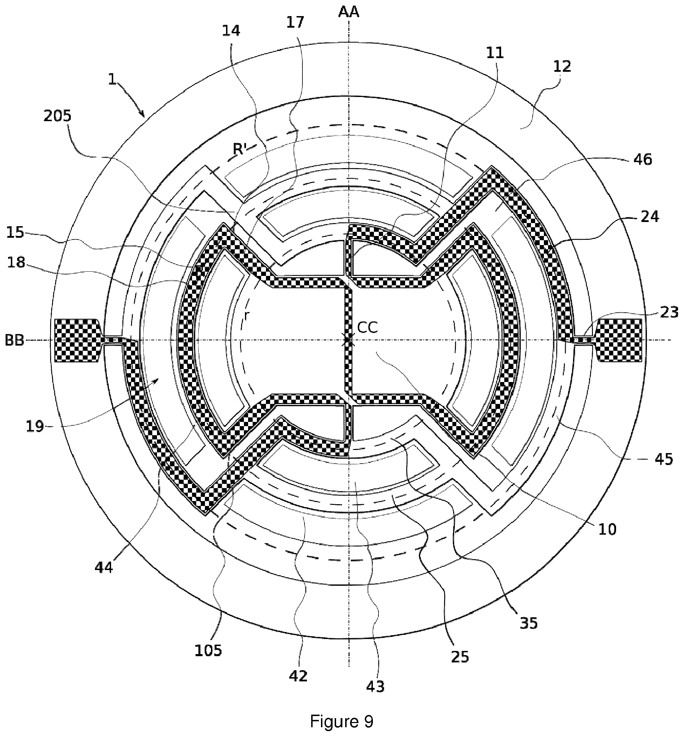

En figure 8 et 9, on a représenté, respectivement, une vue de dessus et un vue de dessous d'un mode de réalisation particulièrement avantageux du dispositif micromécanique selon l'invention, mobile selon deux axes de rotation, AA et BB, perpendiculaires l'un par rapport à l'autre. Dans ce mode de réalisation, le dispositif 1 comprend un premier cadre rigide 14, solidaire de l'élément actif 10, et un deuxième cadre rigide 24, monté mobile en rotation sur le support 12 selon l'axe BB à l'aide de poutres de torsion 23. L'élément actif 10 est lui-même monté solidaire du deuxième cadre rigide 24 par l'intermédiaire de poutres de torsion 11. L'ensemble se distingue du dispositif décrit en regard de la figure 4, en ce que les cadres 14 et 24 ne sont pas rectangulaires, mais constitués de portions de cercle reliées entre elles par des branches radiales.

Plus précisément, le premier cadre 14 comporte deux premières portions de cercle 15 de rayon R, symétriques par rapport à l'axe AA, reliées à l'élément actif 10 par quatre branches radiales 105. De même, le deuxième cadre 24 comprend deux deuxièmes portions de cercle 25 de rayon R, disposées symétriquement par rapport à l'axe BB. Pour des raisons qui apparaîtront par la suite, les premières et deuxièmes portions de cercle 15, 25, étant les portions actives des cadres 14 et 24, sont situées sur un même cercle virtuel de rayon R et de centre l'intersection des axes AA et BB.

Le deuxième cadre 24 comporte encore deux troisièmes portions de cercle 35 de rayon r inférieur à R, concentriques aux deuxièmes portions de cercle 25, et reliées à ces dernières par des branches radiales 205. Il comprend enfin deux quatrièmes portions de cercle 45 de rayon R' supérieur à R, concentriques aux premières portions de cercle 15 et reliées aux deuxièmes et troisièmes portions de cercle 25 et 35, par les branches radiales 205. Les poutres de torsion 11 relient l'élément actif 10 aux troisièmes portions de cercle 35, tandis que les poutres de torsion 23 relient les quatrièmes portions de cercle 45 au support 12, de sorte que l'élément actif 10 est monté sur le support 12 indirectement, par l'intermédiaire du deuxième cadre 24.

Le premier rotor 17, monté en face arrière du dispositif 1, est formé d'une ligne conductrice circulant sur les premières portions de cercle actives 15, via les poutres de torsion 23 et 11, les portions de cercle 35 et 45, et les branches radiales 105 et 205. Ledit rotor 17 dessine un 8 en face arrière de l'ensemble cadre 14 - élément actif 10, de sorte que le courant I parcourt les portions de cercle 15 dans des sens de rotation contraires, formant ainsi deux segments de rotor 18 en arc de cercle, symétriques par rapport à l'axe AA, électro-magnétiquement actifs. Le deuxième rotor 27, monté en face avant du dispositif 1, est également formé d'une ligne conductrice circulant sur les deuxièmes portions de cercle 25, via les poutres de torsion 23, les portions de cercle 35 et 45, et les branches radiales 205. Le circuit formé par le rotor 27 est optimisé en vue de maximiser l'intensité du courant I circulant sur les portions de cercle actives 25, avec la contrainte que son sens de rotation dans les portions de cercle 25 est contraire. La justification de cette contrainte apparaîtra ultérieurement. Les segments de rotor 28 portés par les portions de cercle 25 sont symétriques par rapport à l'axe BB et électro-magnétiquement actifs.

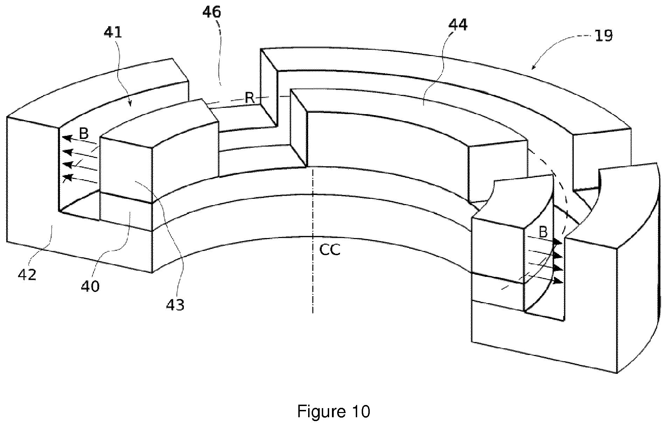

Le dispositif 1 illustré en regard des figures 8 et 9 comprend encore un unique stator 19 de forme circulaire, représenté en coupe en figure 10. Ledit stator 19 est classiquement formé d'un aimant permanent 40, accolé à une structure en matériau ferromagnétique 41, laquelle comprend une pièce inférieure 42 et une pièce supérieure 43, l'ensemble formant un bloc circulaire, d'axe CC perpendiculaire au plan formé par les axes AA et BB. Le stator 19 ainsi constitué, comporte quatre entrefers 44, en arc de cercle, formant un cercle virtuel de rayon R dans le plan parallèle aux axes AA et BB, et un U dans un plan parallèle à l'axe CC. Lesdits entrefers 44 sont agencés et dimensionnés pour recevoir les portions de cercles 15 et 25 avec un minimum de jeu, et sont séparés l'un de l'autre par des tranchées 46. Le stator 19, de part sa forme circulaire, est d'une grande compacité. Il est fabriqué aisément et à peu de frais, par des techniques classiques de tournage. De plus, sa géométrie circulaire assure une excellente homogénéité du champ magnétique B à l'intérieur des entrefers 44, et de faibles pertes.

Les premières et deuxièmes portions de cercle 15 et 25 prennent place à l'intérieur des entrefers 44, tandis que les branches radiales 105 et 205 se déploient à l'intérieur des tranchées 46. On comprend que la forme circulaire du stator 19 implique l'alignement suivant un cercle de rayon R des portions de cercle 15 et 25 tel que mentionné auparavant. Ainsi disposés relativement au stator 19, les cadres 14 et 24 sont actionnés par la circulation d'un courant I, respectivement dans les rotors 17 et 27, selon le principe de Laplace. Le confinement du champ magnétique à l'intérieur des entrefers 44 procure les avantages déjà mentionnés précédemment.

En plus des bénéfices déjà évoqués du dispositif micromécanique 1 selon l'invention, le mode de réalisation décrit en regard des figures 8 à 10, apporte plusieurs avancées. La forme circulaire de l'ensemble assure une plus grande compacité au dispositif 1, de même qu'elle minimise les pertes du champ magnétique par effet de bord. Le fait de n'avoir qu'un unique stator 19 en lieu et place d'une pluralité de ces éléments, permet un montage beaucoup plus aisé de l'ensemble. En effet, dans le cas d'une pluralité de stators, le positionnement minutieux des stators relativement les uns aux autres est nécessaire pour loger précisément chaque portion de stator à l'intérieur d'un entrefer. Cette manipulation est évitée avec un stator unique, la position relative des entrefers 44 étant déterminée uniquement par la conception et la construction du stator 19. La précision du positionnement en est également améliorée. La réduction du nombre de pièces et des opérations de montage a un impact direct au niveau du coût du dispositif. On notera que la seule contrainte liée à l'emploi d'un unique stator est liée au sens du courant circulant dans les rotors 17 et 27. Comme déjà souligné, le champ magnétique B ayant un unique sens de circulation dans le stator 19, le courant I doit circuler dans des sens de rotation opposés dans les segments de rotor 18 et 28. Ceci est obtenu sans difficulté par un agencement judicieux des rotors 17 et 27.

Ainsi a été décrit un dispositif micromécanique à actionnement électromagnétique, mobile selon un ou deux axes de rotation. Bien entendu, la présente invention ne se limite pas aux modes de réalisation décrits ci-dessus, mais s'étend à toutes les variantes à la portée de l'homme de métier, s'inscrivant dans le cadre des revendications ci-après. On notera par exemple, que le dispositif micromécanique selon l'invention est très flexible dans sa structure. Le nombre et le positionnement des stators à l'intérieur du support peut varier en fonction de l'application finale, sans sortir du cadre de l'invention défini par les revendications annexées.

## Revendications

**1.** Dispositif micromécanique à actionnement électromagnétique comportant :

- Un support (12),
- Un élément actif (10) monté mobile en rotation sur ledit support (12) suivant un premier axe AA,
- Un premier rotor (17), formé d'au moins une ligne conductrice, monté solidaire en rotation dudit élément actif (10) également selon l'axe AA, et
- Un premier stator (19) comprenant au moins deux pôles magnétiques opposés (20, 21) séparés par un entrefer (22) dans lequel prend place partiellement ledit rotor (17), ledit rotor (17) comprenant un premier segment (18) séparé dudit élément actif (10) par un premier espace vide (16), ledit stator (19) étant positionné à l'intérieur du support (12) de manière à recevoir ledit segment (18) dans son entrefer (22), ses pôles (20, 21) étant disposés de part et d'autre dudit segment (18), l'un d'eux prenant place à l'intérieur dudit premier espace vide (16),

**caractérisé en ce que** toutes les lignes conductrices du dit segment (18) traversent l'entrefer (22) et sont aptes à transporter un courant circulant dans le même sens et de manière perpendiculaire au champ magnétique B formé par les deux pôles (20, 21).

**2.** Dispositif micromécanique selon l'une des revendications 1, **caractérisé en ce que** ledit rotor (17) s'étend d'un côté du premier axe de rotation AA.

**3.** Dispositif micromécanique selon l'une des revendications 1, **caractérisé en ce que** ledit rotor (17) s'étend de part et d'autre de l'axe de rotation AA.

**4.** Dispositif micromécanique selon la revendication 3, **caractérisé en ce que** ledit rotor (17) comporte un deuxième segment (18), séparé dudit élément actif (10) par un deuxième espace vide (16), symétrique du premier segment (18) par rapport à l'axe AA, et **en ce qu'**un deuxième stator (19) est positionné à l'intérieur dudit support (12) de manière à recevoir ledit deuxième segment (18) dans son entrefer (22), un de ses pôles (20, 21) prenant place dans ledit deuxième espace vide (16).

**5.** Dispositif micromécanique selon la revendication 4, **caractérisé en ce que** ledit rotor forme une spire rectangulaire.

**6.** Dispositif micromécanique selon la revendication 4, **caractérisé en ce que** ledit rotor forme un 8.

**7.** Dispositif micromécanique selon l'une des revendications 4 à 6, **caractérisé en ce qu'**il comporte un cadre rigide (14) monté solidaire en rotation dudit élément actif (10), et portant ledit rotor (17).

**8.** Dispositif micromécanique selon la revendication 7, **caractérisé en ce que** ledit cadre (14) rigide est solidaire dudit élément actif (10).

9. Dispositif micromécanique selon la revendication 7, **caractérisé en ce que** ledit élément actif (10) est monté sur ledit support (12) par l'intermédiaire de deux poutres (11) de torsion, et **en ce que** ledit cadre rigide (14) est solidaire desdites poutres de torsion (11).

10. Dispositif micromécanique selon l'une des revendications 7 à 9, **caractérisé en ce que** ledit cadre (14) est rectangulaire.

11. Dispositif micromécanique selon l'une des revendications 7 à 10, **caractérisé en ce qu'**il comporte :

- Un deuxième cadre rigide rectangulaire (24), interposé entre ledit premier cadre rectangulaire (14) et ledit support (12), monté mobile en rotation sur ledit support (12) selon un deuxième axe de rotation BB perpendiculaire à l'axe AA, ledit élément actif (10) étant monté mobile en rotation indirectement sur ledit support (12) par l'intermédiaire dudit deuxième cadre (24),
- Un deuxième rotor (27), formé d'au moins une ligne conductrice, monté solidaire en rotation dudit deuxième cadre (24), et comportant deux segments (28) parallèles et symétriques à l'axe BB, et
- au moins un troisième et un quatrième stators (29), comprenant au moins deux pôles opposés (30, 31) séparés par un entrefer (32), lesdits troisième et quatrième stators (29) étant positionnés à l'intérieur du support (12), symétriquement par rapport à l'axe BB, de manière à recevoir lesdits segments (28) de deuxième rotor (27) dans leur entrefer respectif (32).

12. Dispositif micromécanique selon la revendication 11, **caractérisé en ce qu'**il comporte une pluralité de stators (19, 29) positionnés à l'intérieur du support (12), et recevant directement dans leur entrefer (22, 32) un segment de rotor (18, 28).

13. Dispositif micromécanique selon l'une des revendications 1 à 12, **caractérisé en ce que** ledit stator (19, 29) comprend au moins un aimant permanent (40), et une structure en matériau ferromagnétique (41), à laquelle il est accolé pour former un U.

14. Dispositif micromécanique selon l'une des revendications 7 à 9, **caractérisé en ce que** ledit cadre rigide (14) comporte deux premières portions de cercle (15) de rayon R, symétriques par rapport à l'axe AA, portant lesdits segments de rotor (18), **en ce qu'**un deuxième cadre rigide (24), interposé entre ledit support (12) et ledit cadre (14), est monté mobile en rotation sur le support (12), selon un deuxième axe de rotation BB perpendiculaire à l'axe AA, par l'intermédiaire de poutres de torsion (23), ledit deuxième cadre rigide (24) comportant deux deuxièmes portions de cercle (25) de rayon R, symétriques par rapport à l'axe BB, lesdits premières et deuxièmes portions de cercle (15, 25) étant situés sur un même cercle virtuel de rayon R et de centre l'intersection des axes AA et BB, et **en ce que** ledit dispositif comprend un deuxième rotor (27) monté sur ledit deuxième cadre rigide (24), formant deux segments (28) portés par lesdites deuxièmes portions de cercle (25), et un unique stator (19) de forme circulaire, comportant quatre entrefers (44) en arc de cercle de rayon R dans lesquels prennent place, respectivement lesdites premières et deuxièmes portions de cercle (15, 25) desdits cadres (14, 24).

15. Dispositif micromécanique selon la revendication 14, **caractérisé en ce que** ledit stator comprend au moins un aimant permanent (40), accolé à une structure en matériau ferromagnétique (41) laquelle comprend une pièce inférieure (42) et une pièce supérieure (43), le tout formant un bloc circulaire, d'axe CC perpendiculaire au plan formé par les axes AA et BB, comportant quatre entrefers (44) en arc de cercle, séparés par des tranchées (46), formant un cercle de rayon R dans le plan parallèle aux axes AA et BB, et un U dans un plan parallèle à l'axe CC.

16. Dispositif micromécanique selon l'une des revendications 14 et 15, **caractérisé en ce qu'**il comporte une face arrière sur laquelle prend place le premier rotor (17) et une face avant sur laquelle prend place le deuxième rotor (27).

17. Dispositif micromécanique selon l'une des revendications 15 à 16, **caractérisé en ce que** lesdites premières portions de cercles (15) sont reliées audit élément actif (10) par des branches radiales (105), **en ce que** ledit deuxième cadre rigide (24) comprend encore deux troisièmes portions de cercle (35) de rayon r inférieur à R, concentriques auxdites deuxièmes portions de cercle (25), reliées à ces dernières par des branches radiales (205) et deux quatrièmes portions de cercle (45) de rayon R' supérieur à R, concentriques auxdites premières portions de cercle (15), reliées aux deuxièmes et troisièmes portions de cercle (25, 35), par lesdites branches radiales (205), et **en ce que** lesdites branches radiales (105, 205) prennent place à l'intérieur desdites tranchées (46).

**Patentansprüche**

1. Mikromechanische Vorrichtung mit elektromagnetischem Antrieb, umfassend:

- einen Träger (12)

- ein aktives Teil (10), das um eine erste Achse AA drehbeweglich auf dem genannten Träger (12) montiert ist,

- einen ersten Rotor (17), bestehend aus mindestens einer Leitung, der zur gemeinsamen Rotation mit dem genannten aktiven Teil (10) ebenfalls um die Achse AA montiert ist,

- einen ersten Stator (19), der mindestens zwei entgegengesetzte Magnetpole (20, 21) aufweist, die durch einen Eisenspalt (22) voneinander getrennt sind, in dem sich teilweise der genannte Rotor (17) befindet,

wobei der genannte Rotor (17) ein erstes vom genannten aktiven Teil (10) durch einen ersten Hohlraum (16) getrenntes Segment (18) umfasst, wobei der genannte Stator (19) im Inneren des Trägers (12) derart angeordnet ist, dass er das genannte Segment (18) in seinen Eisenspalt (22) aufnimmt, wobei seine Pole (20, 21) beiderseits des genannten Segments (18) angeordnet sind, wobei sich einer von ihnen im Inneren des genannten ersten Hohlraumes (16) befindet, **dadurch gekennzeichnet, dass** alle Leiter des genannten Segmentes (18) den Eisenspalt (22) durchqueren und geeignet sind, einen Strom zu führen, der in derselben Richtung und im rechten Winkel zum Magnetfeld B fließt, das von den beiden Polen (20, 21) gebildet wird.

2. Mikromechanische Vorrichtung nach Patentanspruch 1, **dadurch gekennzeichnet, dass** sich der genannte Rotor (17) auf einer Seite der ersten Rotationsachse AA erstreckt.

3. Mikromechanische Vorrichtung nach Patentanspruch 1, **dadurch gekennzeichnet, dass** sich der genannte Rotor (17) beiderseits der ersten Rotationsachse AA erstreckt.

4. Mikromechanische Vorrichtung nach Patentanspruch 3, **dadurch gekennzeichnet, dass** der genannte Rotor (17) ein zweites Segment (18) aufweist, das vom genannten aktiven Teil (10) durch einen zweiten Hohlraum (16), relativ zur Achse AA symmetrisch zum ersten Segment (18), getrennt ist, und dadurch, dass ein zweiter Stator (19) im Inneren des genannten Trägers (12) derart angeordnet ist, dass er das genannte zweite Segment (18) in seinen Eisenspalt (22) aufnimmt, wobei sich einer seiner Pole (20, 21) im genannten zweiten Hohlraum (16) befindet.

5. Mikromechanische Vorrichtung nach Patentanspruch 4, **dadurch gekennzeichnet, dass** der genannte Rotor eine rechteckige Windung bildet.

6. Mikromechanische Vorrichtung nach Patentanspruch 4, **dadurch gekennzeichnet, dass** der genannte Rotor eine 8 bildet.

7. Mikromechanische Vorrichtung nach einem der Patentansprüche 4 bis 6, **dadurch gekennzeichnet, dass** sie einen starren Rahmen (14) aufweist, der zur gemeinsamen Rotation mit dem genannten aktiven Teil (10) montiert ist, und den genannten Rotor (17) trägt.

8. Mikromechanische Vorrichtung nach Patentanspruch 7, **dadurch gekennzeichnet, dass** der genannte starre Rahmen (14) mit dem genannten aktiven Teil (10) fest verbunden ist.

9. Mikromechanische Vorrichtung nach Patentanspruch 7, **dadurch gekennzeichnet, dass** das genannte aktive Teil (10) über zwei Verwindungsträger (11) auf dem genannten Träger (12) montiert ist, und dadurch, dass der genannte starre Rahmen (14) mit den genannten Verwindungsträgern (11) fest verbunden ist.

10. Mikromechanische Vorrichtung nach einem der Patentansprüche 7 bis 9, **dadurch gekennzeichnet, dass** der genannte starre Rahmen (14) rechteckig ist.

11. Mikromechanische Vorrichtung nach einem der Patentansprüche 7 bis 10, **dadurch gekennzeichnet, dass** sie umfasst:

- einen zweiten starren, rechteckigen Rahmen (24), zwischen den genannten ersten rechteckigen Rahmen (14) und den genannten Träger (12) eingefügt, der um eine zweite Rotationsachse BB senkrecht zur Achse AA drehbeweglich auf dem genannten Träger (12) montiert ist, wobei das genannte aktive Teil (10) indirekt über den genannten zweiten Rahmen (24) drehbeweglich auf dem genannten Träger montiert ist,

- einen zweiten Rotor (27), bestehend aus mindestens einer Leitung, der zur gemeinsamen Rotation mit dem genannten aktiven zweiten Rahmen (24) montiert ist und zwei parallele Segmente (28) symmetrisch zur Achse BB aufweist, und

- mindestens einen dritten und einen vierten Stator (29), die mindestens zwei entgegengesetzte Pole (30, 31) durch einen Eisenspalt (32) voneinander getrennt aufweisen, wobei der genannte dritte und der genannte vierte Stator (29) im Inneren des Trägers (12) symmetrisch zur Achse BB derart angeordnet sind, dass sie die genannten Segmente (28) des zweiten Rotors (27) in ihrem jeweiligen Eisenspalt (32) aufnehmen.

**12.** Mikromechanische Vorrichtung nach Patentanspruch 11, **dadurch gekennzeichnet, dass** sie mehrere Statoren (19, 29) im Inneren des Trägers (12) angeordnet aufweist, die in ihren Eisenspalt (22, 32) unmittelbar ein Rotorsegment (18, 28) aufnehmen.

**13.** Mikromechanische Vorrichtung nach einem der Patentansprüche 1 bis 12, **dadurch gekennzeichnet, dass** der genannte Stator (19, 29) mindestens einen Permanentmagneten (40) umfasst und eine Konstruktion aus ferromagnetischem Werkstoff (41), an der er angebracht ist, um ein U zu bilden.

**14.** Mikromechanische Vorrichtung nach einem der Patentansprüche 7 bis 9, **dadurch gekennzeichnet, dass** der genannte starre Rahmen (14) zwei erste Kreisstücke (15) mit Radius R symmetrisch relativ zur Achse AA aufweist, die die genannten Rotorsegmente (18) tragen, dadurch, dass ein zweiter starrer Rahmen (24), zwischen den genannten Träger (12) und den genannten Rahmen (14) eingefügt, um eine zweite Rotationsachse BB im rechten Winkel zur Achse AA drehbeweglich über Verwindungsträger (23) auf dem Träger (12) montiert ist, wobei der genannte zweite starre Rahmen (24) zwei zweite Kreisstücke (25) mit Radius R symmetrisch relativ zur Achse BB aufweist, wobei die genannten ersten und zweiten Kreisstücke (15, 25) auf demselben virtuellen Kreis mit Radius R und dem Schnittpunkt der Achsen AA und BB als Zentrum liegen, und dadurch, dass die genannte Vorrichtung einen zweiten Rotor (27) aufweist, der auf dem genannten zweiten starren Rahmen (24) montiert ist, der zwei Segmente (28) bildet, die von den genannten zweiten Kreisstücken (25) getragen werden, und einen einzigen kreisförmigen Stator (19), der vier Eisenspalte (44) in Kreisbogenform mit Radius R aufweist, in denen sich jeweils die genannten ersten und zweiten Kreisstücke (15, 25) der genannten Rahmen (14, 24) befinden.

**15.** Mikromechanische Vorrichtung nach Patentanspruch 14, **dadurch gekennzeichnet, dass** der genannte Stator mindestens einen Permanentmagneten (40) aufweist, der an einer Konstruktion aus ferromagnetischem Werkstoff (41) angebracht ist, die ein unteres Stück (42) und ein oberes Stück (43) umfasst, wobei alles zusammen einen kreisförmigen Block mit der Achse CC senkrecht zur durch die Achsen AA und BB aufgespannten Ebene bildet, der vier Eisenspalte (44) in Kreisbogenform aufweist, die durch Gräben (46), die einen Kreis mit Radius R in der Ebene parallel zu den Achsen AA und BB bilden und ein U in einer Ebene parallel zur Achse CC.

**16.** Mikromechanische Vorrichtung nach einem der Patentansprüche 14 und 15, **dadurch gekennzeich-**

**net, dass** sie eine Rückseite aufweist, auf der sich der erste Rotor (17) befindet, und eine Vorderseite, auf der sich der zweite Rotor (27) befindet.

**17.** Mikromechanische Vorrichtung nach einem der Patentansprüche 15 bis 16, **dadurch gekennzeichnet, dass** die genannten ersten Kreisstücke (15) mit dem genannten aktiven Teil (10) durch radiale Arme (105) verbunden sind, dadurch, dass der genannte zweite starre Rahmen (24) noch zwei dritte Kreisstücke (35) mit Radius r kleiner als R umfasst, die zu den genannten zweiten Kreisstücken (25) konzentrisch und mit den letzteren durch radiale Arme (205) verbunden sind, und zwei vierte Kreisstücke (45) mit Radius R' größer als R, die zu den genannten ersten Kreisstücken (15) konzentrisch und mit den zweiten und dritten Kreisstücken (25, 35) durch die genannten radialen Arme (205) verbunden sind, und dadurch, dass sich die genannten radialen Arme (105, 205) im Inneren der genannten Gräben (46) befinden.

**Claims**

**1.** Electromagnetically actuated micromechanical device with comprising:

   - a support (12),
   - an active element (10) rotatably mounted on said support (12) along a first axis AA,
   - a first rotor (17) formed of at least one conductive line and fixedly rotatably mounted together with said active element (10), also along the axis AA, and
   - a first stator (19) comprising at least two opposed magnetic poles (20, 21) separated by an air gap (22) in which said rotor (17) is partially placed, said rotor (17) comprising a first segment (18) separated from said active element (10) by a first hollow space (16), said stator (19) being positioned inside the support (12) so as to receive said segment (18) in its air gap (22), its poles (20, 21) being placed on both sides of said segment (18), one of them being placed inside said first hollow space (16),

   **characterized in that** all the conductive lines of said segment (18) are placed across the air gap (22) and are able to transport a current flowing in the same direction and perpendicularly to the magnetic field B formed by the two poles (20, 21).

**2.** Micromechanical device according to claim 1, **characterized in that** said rotor (17) extends on one side of the first axis of rotation AA.

**3.** Micromechanical device according to claim 1, **characterized in that** said rotor (17) extends on both sides of the first axis of rotation AA.

4. Micromechanical device according to claim 3, **characterized in that** said rotor (17) comprises a second segment (18) separated from said active element (10) by a second hollow space (16), symmetrical to the first segment (18) with respect to the axis AA, and **in that** a second stator (19) is positioned inside said support (12) so as to receive said second segment (18) in its air gap (22), one of its poles (20, 21) being placed in said second hollow space (16).

5. Micromechanical device according to claim 4, **characterized in that** said rotor forms a rectangular coil.

6. Micromechanical device according to claim 4, **characterized in that** said rotor forms the shape of an 8.

7. Micromechanical device according to one of the claims 4 to 6, **characterized in that** it comprises a rigid frame (14) fixedly rotatably mounted together with said active element (10) and carrying said rotor (17).

8. Micromechanical device according to claim 7, **characterized in that** said rigid frame (14) is integrally mounted with said active element (10).

9. Micromechanical device according to claim 7, **characterized in that** said active element (10) is mounted on said support (12) by means of two torsion beams (11) and **in that** said torsion beams (11) are fixedly mounted on said rigid frame (14).

10. Micromechanical device according to one of the claims 7 to 9, **characterized in that** said frame (14) is rectangular.

11. Micromechanical device according to one of the claims 7 to 10, **characterized in that** it comprises:

    - a second rectangular rigid frame (24) intercalated between said rectangular frame (14) and said support (12), rotatably mounted on said support (12) along a second axis of rotation BB perpendicular to the axis AA, said active element (10) being indirectly rotatably mounted on said support (12) by means of said second frame (24),
    - a second rotor (27) formed of at least one conductive line, fixedly rotatably mounted together with said second frame (24) and comprising two segments (28) parallel and symmetrical to the axis BB and
    - at least one third and one fourth stators (29) comprising at least two opposed poles (30, 31) separated by an air gap (32), said third and fourth stators (29) being positioned inside the support (12), symmetrically with respect to the axis BB, so as to receive said segments (28) of the second rotor (27) in their respective air gap (32).

12. Micromechanical device according to claim 11, **characterized in that** it comprises a plurality of stators (19, 29) positioned inside the support (12) and directly receiving a rotor segment (18, 28) in their air gap (22, 32).

13. Micromechanical device according to one of the claims 1 to 12, **characterized in that** said stator (19, 29) comprises at least one permanent magnet (40) and a structure made of ferromagnetic material (41) to which it is contiguous to form the shape of a U.

14. Micromechanical device according to one of the claims 7 to 9, **characterized in that** said rigid frame (14) comprises two first circle portions (15) with a radius R, symmetrical with respect to the axis AA, carrying said rotor segments (18), **in that** a second rigid frame (24), intercalated between said support (12) and said frame (14), is rotatably mounted on the support (12), along a second axis of rotation BB perpendicular to the axis AA, by means of torsion beams (23), said second rigid frame (24) comprising two circle portions (25) with a radius R, symmetrical with respect to the axis BB, said first and second circle portions (15, 25) being situated on a same virtual circle with a radius R and with the intersection of the axes AA and BB as a center and **in that** said device comprises a second rotor (27) mounted on said second rigid frame (24), forming two segments (28) carried by said second circle portions (25), and a single stator (19) with a circular shape, comprising four air gaps (44) as a circular arc with a radius R in which said first and second circle portions (15, 25) of said frames (14, 24) are respectively placed.

15. Micromechanical device according to claim 14, **characterized in that** said stator comprises at least one permanent magnet (40) contiguous to a structure made of ferromagnetic material (41) that comprises a lower part (42) and an upper part (43), both parts forming a circular block with an axis CC perpendicular to the plane formed by the axes AA and BB, comprising four air gaps (44) as a circular arc, separated by trenches (46), forming a circle with a radius R in the plane parallel to the axes AA and Bb and a U in a plane parallel to the axis CC.

16. Micromechanical device according to one of the claims 14 to 15, **characterized in that** it comprises a rear face on which the first rotor (17) is placed and a front face on which the second rotor (27) is placed.

17. Micromechanical device according to one of the claims 15 to 16, **characterized in that** said first circle portions (15) are connected to said active element (10) by radial branches (105), **in that** the second rigid frame (24) comprises further two third circle portions (35) with a radius r less than R, concentrical to said second circle portions (25), connected with the latter by radial branches (205), and two fourth circle portions (45) with a radius R' greater than R, concentrical to said first circle portions (15), connected to the second and third circle portions (25, 35) by said radial branches (205), and **in that** said radial branches (105, 205) are placed inside said trenches (46).

Figure 1

Figure 2

Figure 3

Figure 4

Figure 5

Figure 6

Figure 7

Figure 8

Figure 9

Figure 10

**EP 2 990 375 B1**

## RÉFÉRENCES CITÉES DANS LA DESCRIPTION

**Documents brevets cités dans la description**

- WO 2009147304 A
- US 20080143196 A

- WO 2013168485 A